Europäisches Patentamt

European Patent Office

Office européen des brevets

(19)

(11) Publication number: **0 003 559**
**A1**

(12) **EUROPEAN PATENT APPLICATION**

(21) Application number: **79100288.4**

(22) Date of filing: **31.01.79**

(51) Int. Cl.²: **G 05 F 3/14, H 03 K 19/08**

(30) Priority: **03.02.78 JP 115271/78 U**

(43) Date of publication of application: **22.08.79**
**Bulletin 79/17**

(84) Designated Contracting States: **DE FR GB IT NL**

(71) Applicant: **Hitachi, Ltd, 1-5-1, Marunouchi, Chiyoda-ku Tokyo (JP)**

(72) Inventor: **Okada, Yutaka, 4-1-2, Hiyoshi-cho, Kokubunji-shi Tokyo (JP)**
Inventor: **Nakamura, Tohru, 5-4, Honcho, Houya-shi Tokyo (JP)**
Inventor: **Okabe, Takahiro, 2196-36, Hirai Hinodemachi, Nishitama-gun Tokyo (JP)**

(74) Representative: **Schiff, Karl Ludwig et al, Patentanwälte Schiff, v. Füner, Strehl, Schübel-Hopf, Ebbinghaus, Finck Mariahilfplatz 2-3, D-8000 München 90 (DE)**

(54) **Current mirror circuit.**

(57) A current mirror circuit (20) formed of a PNP (NPN) transistor (201) employs as its load an I²L circuit (30), an injector (31) of the I²L circuit (30) being common with those of another group of I²L circuits (40), and a predetermined current being derived from the PNP (NPN) transistor (201) of the current mirror circuit (20).

EP 0 003 559 A1

ACTORUM AG

# Current Mirror Circuit

This invention relates to a semiconductor integrated circuit, and more particularly to a current mirror circuit.

Especially, the invention is concerned with a current mirror circuit which employs an integrated injection logic circuit ($I^2L$).

The $I^2L$ is a new logical circuit which was published in, for example, H.H. Benger and S.K. Wiedman: Merged-Transistor Logic (MTL) - A Low-Cost Bipolar Logic Concept; IEEE J. of SSC, sc-7, 5, p. 340 - 346 (1972, Oct), and K. Hart and A. Slob: Integrated Injection Logic: A New Approach to LSI; IEEE J. of SSC, sc-7, 5, p. 346 - 351 (1972, Oct). The $I^2L$ has attracted attention for such reasons as capability of a high density of integration, wide application, and capability of coexistence with conventional bipolar transistors.

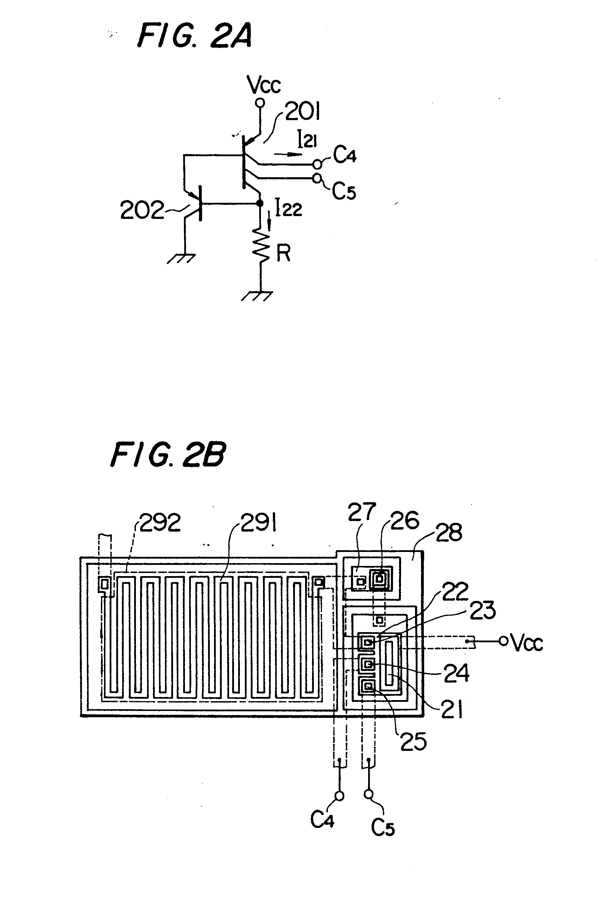

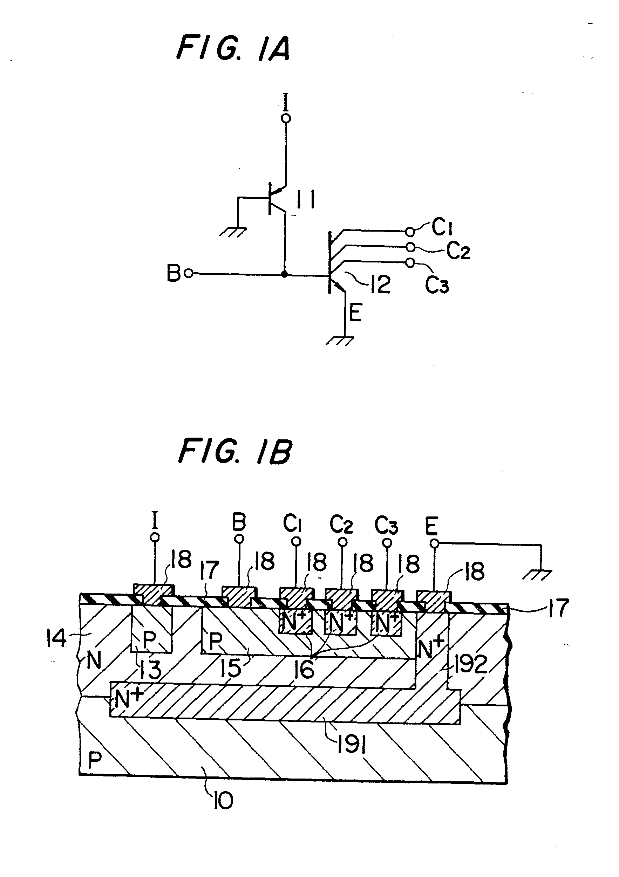

Fig. 1A shows an equivalent circuit of an $I^2L$, while Fig. 1B shows a sectional structure of elements. As illustrated in Fig. 1A, the $I^2L$ is expressed as a combination of a common base PNP transistor 11 and a common emitter NPN transistor 12. The emitter I of the transistor 11 is usually called "injector", and a power supply is connected to this terminal. The base B of the transistor 12 is used as an input terminal, and the collectors C1 to C3 are used as output terminals so as to derive outputs in the multi-collector type. The transistor 12 is such that the emitter and collector of a conventional planar transistor are inversed, and the emitter E is grounded. The situation above described is apparent from the sectional view of Fig. 1B. The PNP transistor 11 is constructed of a lateral transistor, the emitter of which is formed of a P-type semiconductor region 13, the base of which is formed of an epitaxially grown semiconductor layer 14 of N-type conductivity and the collector of which is formed of a P-type semiconductor region 15. The NPN transistor 12 is constructed with the collectors formed of N-type semiconductor regions 16, the base formed of the P-type semiconductor region 15 and the emitter formed of the N-type epitaxial semiconductor layer 14. A buried layer 191 of $N^+$-type conductivity and a semiconductor region 192 of $N^+$-type conductivity serve to lead out a common earth terminal. The region 192 is also called "collar region of $N^+$-conductivity" for preventing the influence of parasitic transistors. Besides contacting with the layer 191, the region 192 is sometimes formed with a shallow portion so as to surround the $I^2L$. Shown at 10 is a semiconductor substrate of P-type conductivity.

The substrate 10 is a silicon (Si) substrate, and the semiconductor layer 14 is an Si epitaxial layer. The semiconductor regions 13, 15, 16 and 192 and layer 191 are formed by thermal diffusion, ion implantation, etc.

As seen from Fig. 1B, the collector of the PNP transistor 11 and the base of the NPN transistor 12 are formed by the identical P-type semiconductor region 15. The base of the PNP transistor 11 and the emitter of the NPN transistor 12 are formed by the N-type epitaxial layer 14 in common.

The $I^2L$ above stated occupies a small area, is capable of low-power operation and is easily brought into coexistence with other functional circuits employing bipolar transistors, so that it is being applied extensively. However, when it coexists with the other functional circuits employing bipolar transistors, the area of the circuit portion other than the $I^2L$ is large and the power dissipation thereof is high, and the features of the $I^2L$ are often lessened as to the whole LSI.

When a minute current is needed as the injector current of the $I^2L$, a current mirror circuit is often employed as a constant current supplying means. The "current mirror circuit" is a circuit which provides a current equal to a certain reference current (given current) from an output terminal. In case where the current mirror circuit is constructed of a multi-collector transistor, currents which correspond to the area ratios of the respective collectors can be supplied.

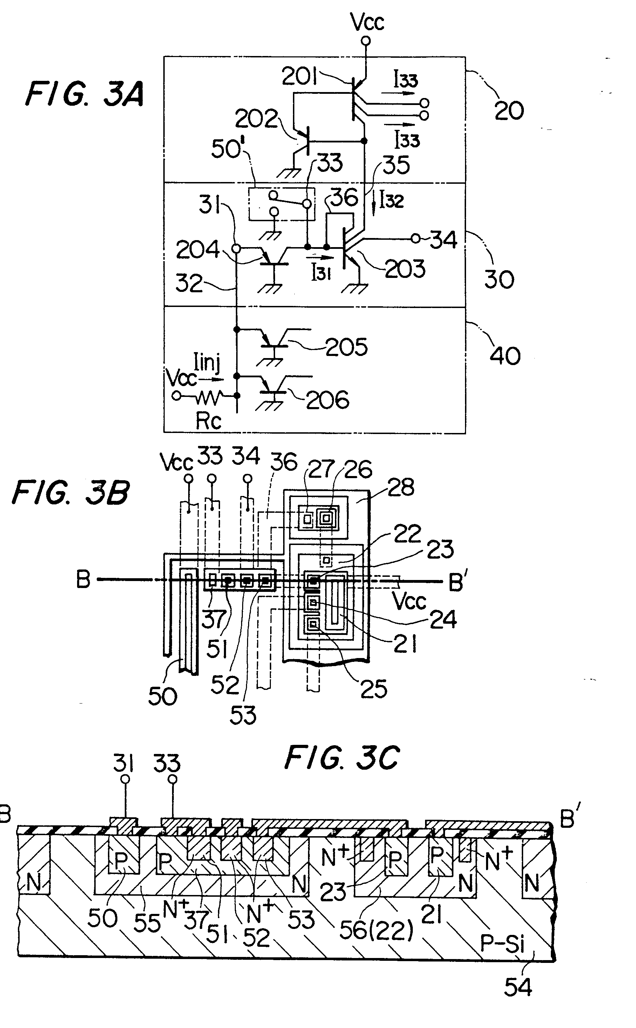

A prior-art current mirror circuit is shown in Fig. 2A. In this circuit, current I21 which is derived from collectors C4 and C5 is equal to current I22 which flows through a resistor R. In case of using this circuit as a current source for supplying a low current (approximately several µA or below), the resistor R requires a great resistance value (several hundreds KΩ or above). With ordinary bipolar transistor processes, accordingly, a pinch resistor must be used. The pinch resistor, however, has the disadvantages that the area is large, that the temperature dependence is inferior, and that a large margin is required for the design on account of a large dispersion and an inferior precision.

Fig. 2B shows a plan pattern for the case that the circuit of Fig. 2A is constructed of an integrated circuit. A P-type region 21, an N-type region 22, and P-type regions 23, 24 and 25 form the emitter, the base, and the collectors of a multi-collector PNP transistor 201, respectively. A P-type region 26, an N-type region 27, and a P-type substrate 28 form the emitter, the base, and the collector of a PNP transistor 202, respectively. Regions 291 and 292 (shown by a one-dot chain line) are P-type and N-type regions respectively, which constitute the pinch resistor. Parts shown by broken lines are metallic interconnections.

As apparent from Fig. 2B, the pinch resistor occupies most of the region of the current mirror circuit. By way of example, when a current of 1 μA is to be derived from the collectors C4 and C5 under Vcc = 5V, the resistance of the resistor R needs to be about 4 MΩ. Then, the occupying area of the resistor part only becomes 310 x 180 $\mu m^2$, which is very unfavorable.

An object of this invention is to eliminate the disadvantage of the prior art current mirror circuit and to provide a current mirror circuit which does not employ a pinch resistor.

Another object of this invention is to provide a current mirror circuit which is constructed by exploiting an $I^2L$ and which is suitable for use in an integrated circuit made up of a large number of $I^2L$'s.

The subject matter of this invention resides in a current mirror circuit in which an $I^2L$ is employed as a load of the current mirror circuit made up of the PNP (NPN) transistors shown in Fig. 2A, the injector of the $I^2L$ being common to those of another group of $I^2L$'s, wherein a predetermined current is derived from the PNP (NPN) transistor of the current mirror circuit.

In the accompanying drawings : -

Fig. 1A (referred to above) is a circuit diagram for explaining an $I^2L$;

Fig. 1B (referred to above) is a sectional view of the structure of elements in the $I^2L$ of Fig. 1A;

Fig. 2A (referred to above) is a circuit diagram for explaining a prior art current mirror circuit;

Fig. 2B (referred to above) is a plan pattern view showing the case that the circuit of Fig. 2A is constructed of an integrated circuit;

Fig. 3A is a circuit diagram showing an embodiment of this invention;

Fig. 3B is a plan pattern view showing the case that the circuit of Fig. 3A is constructed of an integrated circuit; and

Fig. 3C is a sectional view of elements taken along line B - B' in Fig. 3B.

Hereunder, this invention will be described in detail with reference to an embodiment of a current mirror circuit as illustrated in Figs. 3A, 3B and 3C.

Shown in Fig. 3A by a broken line 40 is a logical circuit portion which is constructed of an $I^2L$. An injector current Iinj flows from a power supply Vcc through a resistor Rc to a common injector line 32. The broken line 30 designates a load portion of the current mirror circuit. It constitutes the current mirror circuit together with a further part shown by the broken line 20.

In the current mirror circuit of Fig. 3A, an $I^2L$ which is made up of a lateral PNP transistor 204 and an inverse NPN transistor 203 is provided instead of the resistor R of the prior art current mirror circuit in Fig. 2A. The injector of this $I^2L$ is used in common with those of the $I^2L$ logical circuit portion. In the $I^2L$ 30, one collector 36 of the multi-collector NPN transistor 203 is connected to the base of the transistor itself. When a base terminal 33 of the $I^2L$ 30 is open and current is permitted to flow from an injector terminal 31, it holds that I31 = I32. Since I32 = I33, it holds that I31 = I33.

Merits of the present circuit are as follows.

(1) The current caused to flow to the injector 31 of the $I^2L$ is obtained by using the injectors of another $I^2L$ within the same chip in common. Accordingly, it is unnecessary to provide a pinch resistor anew, and the area can be made smaller than in the prior art to the extent that the pinch resistor has been replaced by one stage of $I^2L$ gate.

For example, in case of supplying a current of 1 µA under Vcc = 5 V, the resistance of the resistor in the circuit of Fig. 2A is several MΩ. A plan view in the case of forming the resistor of a pinch resistor was shown in Fig. 2B.

In contrast, a plan view of the $I^2L$ current mirror circuit according to this invention is shown in Fig. 3B, and an area less than 1/10 of that of the resistor portion in the prior art suffices.

Fig. 3B is a plan pattern showing the case that the current mirror circuit of Fig. 3A is put into an integrated circuit, while Fig. 3C is a sectional view taken along line B - B' in Fig. 3B. In these figures, numerals 51, 52 and 53 designate diffusion regions of $N^+$-type conductivity, which form the multi-collector parts of the $I^2L$. Numeral 50 designates a diffusion region of P-type conductivity which serves as the injector. Numeral 54 indicates a P-type semiconductor (e.g., Si) substrate, and numerals 55 and 56 indicate N-type regions which are diffused layers or epitaxially grown layers.

(2)    Since no pinch resistor is employed in the current mirror circuit portion, currents of small dispersion and high precision can be supplied.

(3)    If the current I33 which the current mirror circuit supplies is caused to flow through another logical circuit of $I^2L$ different from the part 40, both the current source and the logical circuit are constructed of $I^2L$ circuits. Accordingly, the balance of currents is easily taken, and the circuit design is conspicuously facilitated. The current mirror circuit 20 of PNP transistors and the $I^2L$ 30 can have currents set at desired magnitudes by varying the areas of the collectors of the respective transistors, i.e. PNP transistor 201 and NPN transistor 203. By way of example, the areas of the collectors 51 and 53 are made equal, and the area of the collector 25 is made double that of the collector 23. Alternatively, the area of the collector 53 is made double that of the collector 51, and the areas of the collectors 23 and 25 are made equal. At this time, it holds that I33 = 2 I31.

(4)  By controlling the voltage of the base terminal 33 in Fig. 3A, the currents I33 can be switched. By way of example, when the terminal 33 is brought to the earth potential level by the use of a switching element or switching circuit 50', the $I^2L$ 30 is cut off and the current mirror circuit, is also cut off. The switching element or switching circuit 50' sets the potential of the terminal 33 at the open state or the earth state. Accordingly, it is not required to cause any unnecessary current to flow, and the power dissipation of the circuit can be lessened.

(5)  By adding a collector terminal 34 to the $I^2L$ 30, the circuit can be operated while monitoring the currents.

As explained above, the current mirror circuit of this invention is very useful as a minute current-source of small area and high precision. According to this invention, the current mirror circuit can be provided by making the best use of the great merit of the $I^2L$ so that the area of the device is small.

It is also possible to change the polarities of voltages by making the transistors 201, 202 and 204 NPN transistors and the transistor 203 a PNP transistor conversely to the foregoing embodiment.

Patent Claims:

1. A current mirror circuit, characterized by

a first transistor (201) which has a plurality of collectors, in which the first collector is fed back to a base of said first transistor (201), in which an output current is derived from the second collector, and whose emitter is connected to a power supply (Vcc);

a second transistor (203) which has a plurality of collectors (34...36), in which the first collector (36) is fed back to the base (33) of said second transistor (203), in which the second collector (35) is connected to said first collector of said first transistor (201), and whose emitter is grounded; and

a third transistor (204) whose base is grounded, whose collector is connected to said base (33) of said second transistor (203), and whose emitter (31) serves as a current supplying terminal.

2. A current mirror circuit according to claim 1, characterized in that the feedback of the first collector of said first transistor (201) to said base thereof is effected through a fourth transistor (202), a collector of which is grounded, a base of which is connected to said first collector of said first transistor (201) and an emitter of which is connected to said base of said first transistor (201).

3. A current mirror circuit according to claim 2, characterized in that said first and fourth transistors (201, 202) are PNP transistors, said second transistor (203) is an NPN transistor, said third transistor (204) is a lateral PNP transistor, an $I^2L$ is constructed of said second and third transistors (203, 204) and said emitter (31) of said third transistor (204) serving as an injector of said $I^2L$ is constructed in common with an injector of a logical circuit of an $I^2L$ construction.

4. A current mirror circuit according to any of claims 1 to 3, characterized in that said base (33) of said second transistor (203) is provided with a switching element or switching circuit (50') which is connected to either an earth terminal or an open terminal.

5. A current mirror circuit according to any of claims 1 to 4, characterized in that an area of said second collector (35) of said second transistor (203) is made $n$ times ($n$: positive integer or fraction) as large as an area of said first collector (36) thereof and an area of said second collector of said first transistor (201) is made $m$ times ($m$: positive integer or fraction) as large as an area of said first collector thereof, whereby a current to be derived from said second collector of said first transistor is made $n \times m$ times as high as a base current of said second transistor (203).

6. A current mirror circuit according to claim 1, 4 or 5, characterized in that said second transistor (203) is an NPN transistor, said third transistor (204) is a lateral PNP transistor, an $I^2L$ is constructed of said second and third transistors (203, 204), and an emitter (31) of said third transistor serving as an injector of said $I^2L$ is constructed in common with an injector of a logical circuit of an $I^2L$ construction.

FIG. 2A

FIG. 2B

## FIG. IA

## FIG. IB

0003559

FIG. 3A

Vcc

201

$I_{33}$

202

20

50'

33

35

31

36

$I_{32}$

204

34

32

$I_{31}$

203

30

40

205

$I_{inj}$

Vcc

206

Rc

FIG. 3B

Vcc 33 34 36

27 26

28

22 23

B ————— B'

Vcc

24

37

21

51

52

25

50

53

FIG. 3C

31 33

B                                                                    B'

N    P    P                    N⁺    P    P    N⁺    N

N                            N    23

50  55  N⁺  37  51  52  53    56(22)  21    P-Si

54

**0003559**

**European Patent Office**

**EUROPEAN SEARCH REPORT**

Application number

EP 79 10 0288

## DOCUMENTS CONSIDERED TO BE RELEVANT

| Category | Citation of document with indication, where appropriate, of relevant passages | Relevant to claim |
|---|---|---|
| X | IEEE TRANSACTIONS ON COMPUTERS, vol. C-26, nr. 12, December 1977 New York, U.S.A. DAO et al. "Multivalued Integrated Injection Logic", pages 1233-1241 <br><br> * Figures 2,3,10; page 1234, right-hand column, lines 3-17; page 1238, left-hand column, lines 1-23 * <br><br> -- | 1-3,5, 6 |
| X | RADIO FERNSEHEN ELEKTRONIK, vol. 26, nr. 8, april 1977 Berlin, DD TEICHMANN: "I2L-Schaltungstechnik" pages 245-247 <br><br> * Figures 1a,9b,9c,10; page 245 from middle column, line 22 - right-hand column, line 1; from page 246, right-hand column, line 32 - page 247, left-hand column, line 17 * <br><br> -- | 1,3,6 |
| A | IEEE JOURNAL OF SOLID-STATE CIR-CUITS, vol. SC-12, nr. 6, december 1977 New York, U.S.A. FREDERIKSEN et al. "A Single Chip All-Bipolar Camera-Control Inte-grated Circuit", pages 673-684 <br><br> * Figure 13; from page 679, right-hand column, line 17 - page 680, left-hand column, line 33 * <br><br> -- <br><br> ./. | 1,5 |

**CLASSIFICATION OF THE APPLICATION (Int. Cl.²)**

G 05 F 3/14
H 03 K 19/08

**TECHNICAL FIELDS SEARCHED (Int.Cl.²)**

G 05 F
H 03 K

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 05-04-1979 | FEUER |

EPO Form 1503.1 06.78

## DOCUMENTS CONSIDERED TO BE RELEVANT

| Category | Citation of document with indication, where appropriate, of relevant passages | Relevant to claim |
|---|---|---|
| A | <u>US - A - 3 947 704</u> (BLAUSCHILD)<br><br>* Figures 1,3,4; column 1, lines 24-28; from column 2, line 6- column 3, line 68; column 5, lines 2-60 *<br><br>-- | 1 |
| A | <u>FR - A - 2 353 959</u> (SIEMENS)<br><br>* Figure 1; page 1, lines 12-33; from page 2, line 5 - page 4, line 8 *<br><br>-- | 1,5,6 |
| A | ELECTRONICS LETTERS, vol. 12, nr. 10, 13th May 1976<br>Hitchin Herts, G.B.<br>KANEKO et al. "Stacked 12L Circuit", pages 249-250<br><br>* Figure 1; from page 249, right-hand column, line 60 - page 250, left-hand column, line 30 *<br><br>-- | 6 |
| A | NARICHTEN ELEKTRONIK, vol. 31, nr. 8, August 1977<br>Heidelberg, DE<br>HOMBURG: "MTL/12L vereint die Vorteile der Bipolar-mit denen der FET-Technik", pages 229-231<br><br>* Figures 1,3,7; page 229, middle- and right-hand columns *<br><br>---- | 1 |

**CLASSIFICATION OF THE APPLICATION (Int. Cl.²)**

**TECHNICAL FIELDS SEARCHED (Int. Cl.²)**

EPO Form 1503.2   06.78